# EUROPEAN PATENT APPLICATION

(11) **EP 3 185 656 A1**
(43) Date of publication of application: **28.06.2017**
(21) Application number: 15202279.4
(22) Date of filing: 23.12.2015
(51) Int. Cl.: H05K 1/03, H05K 1/02, H05K 3/28

(54) **MODULE FOR TEXTILE APPLICATIONS**

(71) Applicant: Universiteit Gent, 9000 Gent (BE); IMEC VZW, 3001 Leuven (BE)
(72) Inventor: VAN KEYMEULEN, Bjorn, 9620 Zottegem (BE)
(74) Representative: DenK iP

(57) **Abstract**

The present invention relates to a module for performing measurements on a textile product comprising at least one electric circuit and at least one terminal (22) connected with said at least one electric circuit via a conductive wiring layer, wherein said terminal is arranged for clamping a conductor (12) of the textile product to be measured at a first clamping point (24) to said electric circuit and for establishing electrical connection with said conductor of said textile product.

## Description

### Field of the invention

The present invention is generally related to the field of devices for introducing electronic functionalities in textile applications and in particular performing measurements in textile applications.

### Background of the invention

When electronic modules are completely integrated in textile products and they stop functioning, the smart textile product is at least partially not functional anymore. Repairing the product is mostly impossible due to the high level of integration. Therefore a lower level of integration whereby electronic modules can be swapped, is desirable for certain applications.

If electronics are integrated in e.g. disposable diapers, they also have to be thrown away in case they are completely integrated. This brings along recycling and cost issues.

Some textile products need to be cleaned using industrial washing processes. However, no methods to make electronics washable are available for such industrial washing processes. Furthermore, making electronics washable also brings along costly manufacturing processes and hence products.

Electronics have to be powered (with cable, batteries, wireless charging, ...). Efficiency of wireless charging is not that good over a long distance, e.g. when the user is wearing the textile product. Walking around with a cable is not very comfortable. Batteries have a certain life time, so the electronic module has to be recharged or the modules will not be functional anymore after a certain time. Removable, rechargeable modules can solve this problem. These examples illustrate the usefulness of stand-alone electronic modules, which can be removed and reused.

Certain existing technologies and methodologies are using removable and reusable modules which are attached to a connector which is already present in the textile application. However, some of the abovementioned problems are not, or only partially, solved by these methods. Introducing a connector in a textile application which has to be washed, can bring reliability problems along. Introducing a connector in a textile application brings the production cost of this textile application to a higher level, which can be e.g. a problem in disposable applications. Furthermore, if the textile product is disposed at the end of its life cycle, the connector is thrown away, which brings in turn ecological, economical and logistical implications along.

Hence, there is a need for a reusable stand-alone electronic module for use in smart textile applications, wherein at least some of these drawbacks are avoided or overcome.

### Summary of the invention

It is an object of embodiments of the present invention to provide for a removable and reusable module suitable for measurements on a smart textile product.

The above objective is accomplished by the solution according to the present invention.

In a first aspect the invention relates to a module use on a textile product comprising at least one electric circuit and at least one terminal connected with the at least one electric circuit via a conductive wiring layer, wherein the terminal is arranged for clamping a conductor of the textile product to be measured at a first clamping point to the electric circuit and for establishing electrical connection with said conductor of the textile product.

The proposed solution indeed allows removing the module from one textile product on which it was employed and reusing it for example for performing measurements on another textile product provided with suitable electrical connections or on the same textile product. Due to the fact that an electrode can be clamped to the terminal at a clamping point, electrical connection between the module and the textile product to be measured is achieved in a direct, simple and straightforward way. The proposed solution can also be realised cost-effectively.

In a preferred embodiment the at least one electric circuit and the conductive wiring layer is provided on a support layer. Most preferably the support layer is flexible.

In one embodiment the module comprises a second clamping point. The second clamping point is preferably combined with an additional terminal to introduce electrical redundancy.

In another embodiment the module comprises means for powering the electronic circuit. Said means for powering is preferably a rechargeable battery.

In one embodiment the at least one electric circuit and the conductive wiring layer are insulated from the outside world with an encapsulation product.

In one embodiment the module is arranged for communicating measurement results to a processing device. In another embodiment the module comprises internal processing means.

In one embodiment the module has a contact resistance of less than 20 ohm. This makes the module suitable for impedance measurements.

The invention also relates to a system comprising a module for performing measurements as previously described and a textile product comprising at least one conductor.

In another aspect the invention relates to the use of the module as previously described for performing measurements.

In yet another aspect the invention relates to the use of the module as described above for charging said battery via the at least one terminal.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, wherein like reference numerals refer to like elements in the various figures.
Fig.1 illustrates a textile carrier with electrical conductors.
Fig.2 illustrates an embodiment of the reusable module according to the invention being applied on a textile carrier with conductors.
Fig.3A illustrates the reusable module in combination with the textile carrier and conductors with additional clamping point for mechanical redundancy. Fig.3B illustrates the reusable module in combination with the textile carrier and conductors with additional clamping point for mechanical redundancy and additional terminal for electrical redundancy.
Fig.4A and Fig.4B illustrate the reusable module in combination with the textile carrier and conductors with additional clamping point for mechanical redundancy with multiple conductors inside the textile carrier.
Fig.5 illustrates the use of the module for recharging its battery via the terminal.
Fig.6 illustrates solutions for stiffening a clamping point.

### Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

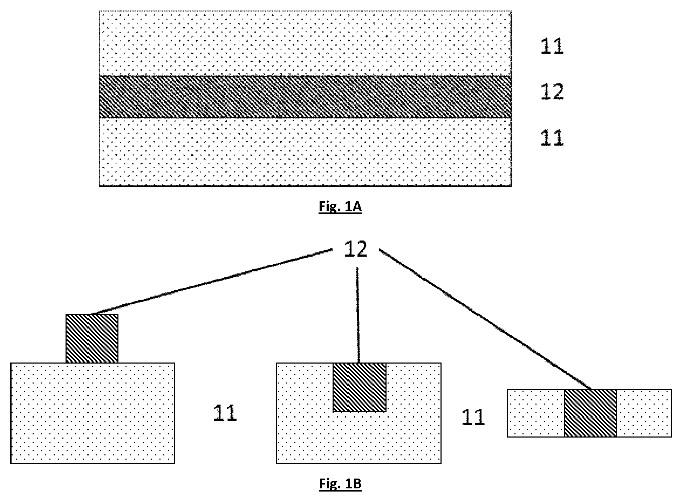

The present invention proposes a reusable module capable of e.g. performing measurements on a textile product. A textile product, in the frame of this invention, can be seen as a material which exists of filaments or fibres. Examples of textile products are cotton fabrics, nonwoven carpets, disposable diapers, etc. The module comprises at least one electric circuit and at least one terminal connected with the at least one electric circuit on the module via a conductive wiring layer. The conductive wiring layer is typically a subpart of the electric circuit of the module. Fig.1 illustrates some suitable systems of one or more conductors for a textile product. In Fig.1A a top view of the product (11) is provided. The system of conductors (12) is in Fig.1B on the left hand side on top, in the middle and on the right hand side inside the textile product. On the right side of Fig.1B the conductor is accessible from both up and down side of the textile.

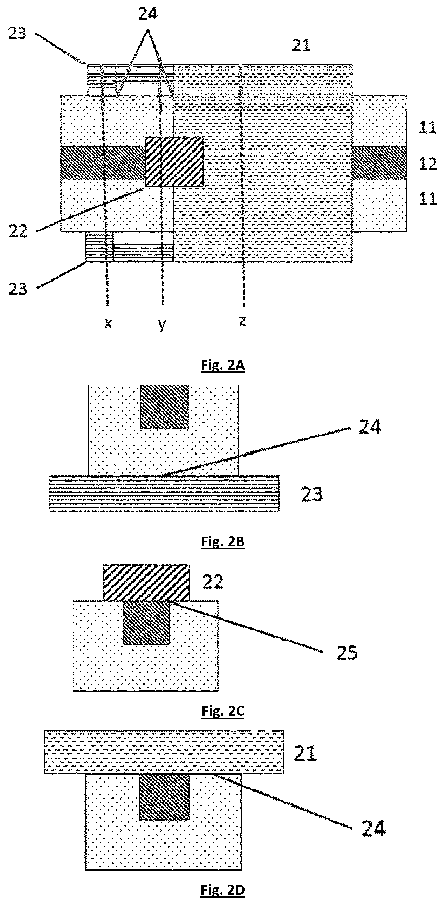

Fig.2 represents an embodiment of the reusable module according to the invention. The reusable module is shifted over a carrier textile (11) with conductor (12) via a clamping point. By shifting the textile carrier over or through the clamping point, the textile carrier and the reusable module are mechanically attached to each other at the clamping point (24). Although in this description we refer to a clamping point, clamping point is to be construed as any position where an electrode of the textile carrier can be mechanically clamped. A terminal (22) establishes at the clamping point (24) an electro-mechanical contact (25) between the conductor (12) in the carrier textile and the functional island (21) that comprises the at least one electric circuit of the module. Hence, by clamping the carrier textile with conductor in an appropriate way to the module also an electro-mechanical contact is created between an electric circuit of the module and the conductor (12) in the carrier textile. The clamping point is obtained by introducing a reinforcement (23) which allows shifting the textile carrier between the reinforcement and the functional island (21) and the terminal. This reinforcement can typically be made very flexible and bendable to enable easy attachment of the carrier textile at the clamping point. Nevertheless, this reinforcement has to be stiff enough to guarantee a reliable mechanical and electromechanical contact between the module and the electrical terminal (22).

The proposed solution can be realised cost-effectively and this because of two reasons. The textile product itself does not need specific treatments when it has the system of conductors arranged as shown in Fig.1. Moreover, the module itself can be manufactured by standard PCB-based processing and products and conventional electronic circuitry. Conventional electronic components can indeed be employed, which yields a significant cost advantage. However, other options are available as well. For example, the reusable module can be made of a low cost printable electronics foil attached to a more rigid surface for mechanical rigidity.

The reusable module can be added directly on conductors integrated in a textile material. The direct attachment applied here reduces the cost of an additional rigid or flexible part on the textile product. The electronic module is added by clipping it on or shifting it over the textile carrier. Electrical contact is established by means of a mechanical force.

The electronic module typically has a battery to deliver power to the electronic circuitry in case of a measurement system inside the module. The battery can be recharged after the module is removed from the textile carrier by wireless or wired charging. Wired charging can be established using the same electrical terminals as for the textile interconnection. The rechargeable battery can be recharged by means of the same interconnection system which is used to make the electrical contact with the conductive wiring network inside the textile product. The charging unit, that recharges the battery, is provided with a conductive wiring system as well as a carrier for this wiring system similar to the system of conductors of the textile product of Fig.1. The carrier and/or the conductive wiring system of the charging unit do not have to be made from the same materials as the textile product. Typically this charging unit and its conductive wiring and carrier system are made with products which have a better durability compared to the textile product.

The electrical contact is established by electro-mechanical clamping. The mechanical clamping can be achieved in several ways. A first method is by using the encapsulant (PDMS) of the electronics in combination with conductive brushes, which establish the electrical contact. The brushes are made of conductive material like e.g. stainless steel. The holders of the brushes are soldered to the flexible island. These holders may be made of copper or copper plated stainless steel and serve as interface between the textile side and the electronics side of the system. In a second method the encapsulant is used in combination with Pogo pins. The Pogo pins have the same functionality as the brushes. An additional advantage of using Pogo pins is that they have a spring inside. In this way, they inherently apply a mechanical force to the textile when inserted.

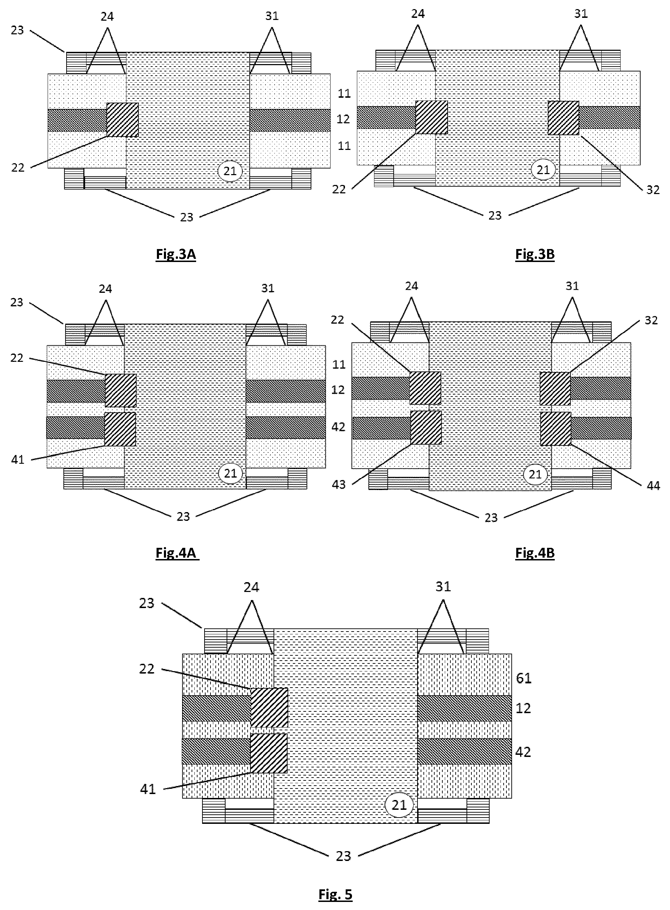

To integrate the reusable module the module has to be shifted over the textile carrier (see Fig.2). A first electrical contact (22) is achieved at the left clamping point (24) of Fig.3, but to establish a reliable solution advantageously also a second clamping point (31) of the textile substrate is provided, see Fig.3A. The second clamping point can also be combined with a terminal (e.g. an electromechanical contact point) (32) to introduce redundancy. Fig.3B provides an illustration. The redundancy can be obtained by shorting the two terminals that establish a connection with the same conductor inside the textile product. The shorting can be obtained by means of the electric wiring system inside the module.

Fig.4 shows embodiments where the module comprises multiple terminals per clamping point. Each terminal (22 and 41 in Fig.4A and 22, 32, 43, 44 in Fig.4B) accesses the system of conductors of the textile product at one location. The conductors inside the textile product can be non-connected or connected with each other, depending upon the desired application. For a two- or more-electrode based impedance measurement the conductors inside the textile product are typically not electrically connected with each other. Unless the conductors are typically not electrically connected with each other, the terminals can short them by means of the electrical wiring system inside the module if the application requires this.

The same terminals to make the electromechanical contact with the textile product can be used to charge the reusable module (Fig.5). In this case, the textile carrier with conductors is replaced with a generic, reliable carrier substrate (61) with conductors. The carrier substrate (61) is part of the charging apparatus. This is an advantage due to the fact that the amount of terminals is lower, which brings along a smaller conductive wiring system inside the module. On its terms this results in cost savings (less terminals, less conductive material, less encapsulation, less support layer, etc.) and comfort increase (smaller size, etc.).

The electronic module is totally insulated for comfort and safety reasons. The components of the module are insulated electrically from the outside world, except the terminals at the positions where they make contact with the conductive wiring of the textile product. The insulation typically exists of one or more encapsulation products depending upon the application field. One encapsulation can be a coating on top of the electric circuit to protect against moisture, where an additional (thick) elastomer coating (e.g. PDMS, TPU,...) can be applied on top of the whole concept to protect against mechanical and temperature influences.

The functional island (21) comprises the one or more electric circuits and the conductive wiring layer. Advantageously, the electric circuits and the conductive wiring layer are provided on a support layer. Typically such a support layer is an FR4 substrate, PI, PET and PEN. The above-mentioned encapsulation product is usually also present on top of the functional island.

The module is preferably equipped for communication with some processing means, e.g. a transceiver which can e.g. receive measurement results from the module, send measurement specifications to the module, etc. This tranceiver can forward the measurement data to a local (or cloud based) database. From this database a processing unit will determine when an intervention is necessary.

As an alternative, the module may comprise an internal processor. In this way, the module itself already determined when an intervention is needed. This can overcome the need for a central processing unit and reduce the amount of communication cycles needed in the previous mentioned embodiment.

In order to perform impedance measurements, more in particular to obtain reproducible measurement data, the module should have an acceptable contact resistance. Acceptable, in this case, is between 0Ω and preferably 1-2Ω but can go up to 10Ω or more without introducing totally useless data.

An example of a textile carrier with electrical conductors is a product where woven conductive yarns are applied inside a disposable diaper. In general the carrier can be a nonwoven or woven fabric or a combination of both. The electrical conductors are added to the textile carrier by means of printing ink, by weaving, knitting or embroidering or by any other suitable process.

The textile carrier can so be used as mechanical reinforcement. For this purpose an adhesive layer can be applied on the textile carrier. The textile carrier, together with the electronic module, has to be folded and glued against the global structure.

The conductors in the textile substrate can act as a passive electrode system and fulfil actuator or sensor features.

When the electronic module has to be removed, e.g. because the textile has reached its life time or the battery is empty, the module can be shifted back. In this way, the electronic module can be cleaned and recharged.

The sensor data generated by the electronics is typically transferred wirelessly during the lifetime of the textile.

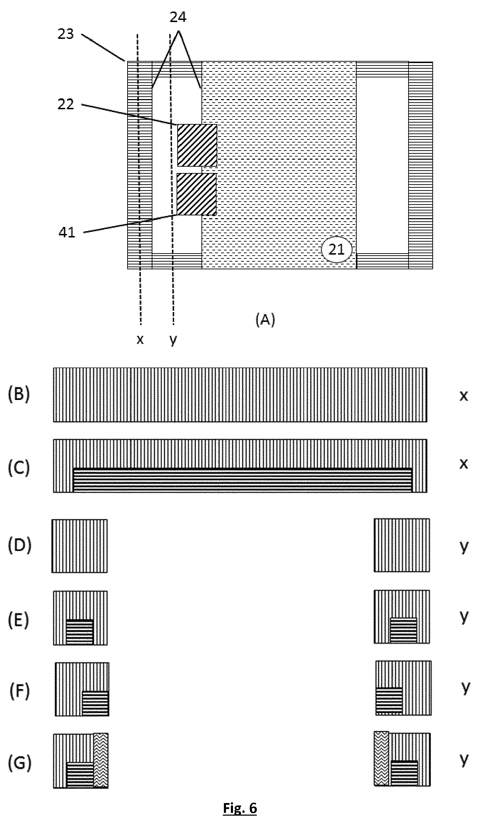

To produce the module various processing techniques and designs can be considered. Especially at the clamping point a variety of design choices are available, see Fig. 6. It can be seen that the clamping area can be made just of encapsulation material (combination Fig. 6. B & D). A stiffener can be placed at section x to reinforce the outer side of the module and/or the outer sides of the module at section y. Following combinations are possible: Fig. 6B-E, C-E and C-D. The stiffener can be made of a flexible or rigid material. One method to introduce this layer is by introducing it during the PCB manufacturing by implementing the support layer for the conductive wiring system at those locations with or without conductors on top of it. One can also place this stiffener at the outer side of the clamping point, see Fig. 6-F. One can also introduce next to the stiffener an additional protection (semi-flexible or rigid) over the whole clamping area, as depicted in Fig. 6-G. One advantage of the latest option is that it protects the encapsulant completely in the clamping zone.

The proposed solution offers many advantages. The production cost of electronic modules remains low as a conventional PCB manufacturing process can be applied. It is further to be noted that also the production cost of conductive textiles to be used with the proposed reusable module remains limited, as there are very few additional requirements to the textile product. For example, no mechanical clamping system is added on the textile product. Conventional roll-to-roll manufacturing can be considered for the textile products. The flexibility of the electronics module makes it comfortable to wear. The electronic module can be cleaned and sterilized after removal of the textile. The reusability of the module can amount to more than 10.000 mechanical clamping cycles.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. Module for use on a textile product, said module comprising at least one electric circuit and at least one terminal (22) connected with said at least one electric circuit via a conductive wiring layer, wherein said terminal is arranged for clamping a conductor (12) of a textile product-at a first clamping point (24) to said electric circuit and for establishing electrical connection with said conductor of said textile product.

2. Module as in claim 1, wherein said at least one electric circuit and said conductive wiring layer is provided on a support layer.

3. Module as in claim 2, wherein said support layer is flexible.

4. Module as in any of claims 1 to 3, comprising a second clamping point (31).

5. Module as in claim 4, wherein said second clamping point is combined with an additional terminal (32).

6. Module as in any of the previous claims, comprising means for powering said electronic circuit.

7. Module as in claim 6, wherein said means for powering is a rechargeable battery.

8. Module as in any of the previous claims, wherein said at least one electric circuit and said conductive wiring layer are insulated from the outside world with an encapsulation product.

9. Module as in any of the previous claims, arranged for communicating measurement results to a processing device.

10. Module as in any of claims 1 to 8, comprising internal processing means.

11. Module as in any of the previous claims, having a contact resistance of less than 20 ohm.

12. Module as in any of the previous claims, wherein said clamping point is supported by a stiffener.

13. System comprising a module for performing measurements as in any of the previous claims and a textile product comprising at least one electrode.

14. Use of the module as in any of claims 1 to 12 for performing measurements.

15. Use of the module as in any of claims 8 to 12 for charging said battery via said at least one terminal.
